# EUROPEAN PATENT APPLICATION

(11) **EP 4 294 156 A1**
(43) Date of publication of application: **20.12.2023**
(21) Application number: 21955373.2
(22) Date of filing: 30.08.2021
(51) Int. Cl.: H10K 59/95, G09G 3/20, G09F 9/33

(54) **LIGHT-EMITTING SUBSTRATE AND DISPLAY APPARATUS**

(71) Applicant: BOE Technology Group Co., Ltd., Beijing 100015 (CN); Hefei Xinsheng Optoelectronics Technology Co., Ltd., Xinzhan Industrial Park Hefei Anhui 230012 (CN)
(72) Inventor: WU, Xintao, Beijing 100176 (CN); XU, Zouming, Beijing 100176 (CN); TIAN, Jian, Beijing 100176 (CN); LIU, Chunjian, Beijing 100176 (CN); LEI, Jie, Beijing 100176 (CN); WANG, Jie, Beijing 100176 (CN); ZHANG, Jianying, Beijing 100176 (CN); XU, Jiawei, Beijing 100176 (CN); XIE, Xiaodong, Beijing 100176 (CN); HE, Min, Beijing 100176 (CN); XU, Wenjie, Beijing 100176 (CN); ZHANG, Xinxiu, Beijing 100176 (CN); ZHAO, Xue, Beijing 100176 (CN); SANG, Huayu, Beijing 100176 (CN)
(74) Representative: Cohausz & Florack
(86) International application number: PCT/CN2021/115479
(87) International publication number: WO 2023/028794

(57) **Abstract**

Disclosed in embodiments of the present disclosure are a light-emitting substrate and a display apparatus, comprising: a base substrate; a first electrically conductive layer, located on the base substrate, the first electrically conductive layer comprising multiple common voltage lines and multiple first connection lines spaced apart from each other, and the multiple common voltage lines extending along a first direction and being arranged along a second direction; a first insulating layer, located at a side of the first electrically conductive layer distant from the base substrate; and a second electrically conductive layer, located at a side of the first insulating layer distant from the base substrate. The second electrically conductive layer comprises multiple first bridge parts spaced apart from each other. At least one of the multiple common voltage lines comprises multiple signal line segments spaced apart from each other.

## Description

### Technical Field

The present disclosure relates to the field of display, in particular to a light-emitting substrate and a display apparatus.

### Background

With the development of light-emitting diode technology, backlights that use light-emitting diodes with a sub-millimeter or even micrometer size have been widely used. Thus, not only an image contrast of transmission-type display products using the backlights can reach the level of organic light-emitting diode (OLED) display products, but also products can retain the technical advantage of the liquid crystal display (LCD) to improve a display effect of the image and provide users with a better visual experience.

### Summary

The light-emitting substrate provided by the embodiments of the present disclosure includes: a base substrate; a first conductive layer on the base substrate; where the first conductive layer includes a plurality of common voltage lines and a plurality of first connection lines arranged at intervals; and the plurality of common voltage lines extend along a first direction and are arranged along a second direction; a first insulating layer on a side, away from the base substrate, of the first conductive layer; and a second conductive layer on a side, away from the base substrate, of the first insulating layer; where the second conductive layer includes a plurality of first bridge portions arranged at intervals from each other; where at least one of the plurality of common voltage lines includes a plurality of signal line segments arranged at intervals; in the same common voltage line, two adjacent signal line segments are electrically connected through the first bridge portion, and at least one first connection line is at a line segment gap between the two adjacent signal line segments; and at the line segment gap between the two adjacent signal line segments in the common voltage line, an orthographic projection of the first bridge portion on the base substrate overlaps with an orthographic projection of the first connection line on the base substrate.

In some examples, an electric field is between the first bridge portion and the first connection line of which orthographic projections on the base substrate overlap; and a direction of the electric field points from the first conductive layer to the second conductive layer.

In some examples, the second conductive layer further includes a first connection part and a second connection part arranged at intervals from each other; and a first terminal of the first connection line is electrically connected to the first connection part through a first via hole, and a second terminal of the first connection line is electrically connected to the second connection part through a second via hole; where the first via hole and the second via hole penetrate the first insulating layer.

In some examples, the orthographic projection of the first connection line on the base substrate covers an orthographic projection of the first via hole on the base substrate, and an orthographic projection of the first connection part on the base substrate covers the orthographic projection of the first via hole on the base substrate; and the orthographic projection of the first connection line on the base substrate covers an orthographic projection of the second via hole on the base substrate, and an orthographic projection of the second connection part on the base substrate covers the orthographic projection of the second via hole on the base substrate.

In some examples, a width in the first direction of an area where the first connection part covers the first via hole is greater than a width of the first connection line in the first direction; and a width in the first direction of an area where the second connection part covers the second via hole is greater than the width of the first connection line in the first direction.

In some examples, a width of the first bridge portion in the first direction ranges from 100 microns to 250 microns, and the width of the first connection line in the first direction ranges from 0.6 microns to 2.5 microns.

In some examples, a length of the first connection line in the second direction is greater than a length of the first bridge portion in the second direction.

In some examples, a first gap is between a side of the first bridge portion extending to the first connection part and the first connection part; a second gap is between a side of the first bridge portion extending to the second connection part and the second connection part; and at least one of a width of the first gap or a width of the second gap ranges from 20 microns to 50 microns.

In some examples, a width of a gap between the first connection line and the signal line segment in the first direction ranges from 20 microns to 50 microns.

In some examples, in a direction perpendicular to a plane where the base substrate is located, a thickness of the first bridge portion is greater than or equal to a thickness of a first connection part and a second connection part in the second conductive layer.

In some examples, the second conductive layer further includes a plurality of pads; one terminal of the first connection part is electrically connected to one of the pads, and another terminal of the first connection part is electrically connected to a first terminal of the first connection line; and one terminal of a second connection part is electrically connected to another pad of the plurality of pads, and another terminal of the second connection part is electrically connected to a second terminal of the first connection line.

In some examples, the plurality of common voltage lines are located in a display area; the display area further includes a plurality of light-emitting cells; and each of the light-emitting cells includes a driving circuit and a plurality of light-emitting elements; where the driving circuit includes a common voltage terminal and the output terminal; the plurality of light-emitting elements are sequentially connected in series between a driving voltage terminal and the output terminal; the common voltage terminal is electrically connected to the common voltage line; and pads are electrically connected to at least one of the plurality of light-emitting elements and the driving circuit; the plurality of light-emitting elements in the light-emitting cell are divided into M element groups; each of the element groups includes N light-emitting elements arranged along the first direction; the M element groups are arranged along the second direction; N is an integer greater than 0; and M is an integer greater than 0; a plurality of element groups are numbered sequentially along an order of pointing from the driving voltage terminal to the output terminal; a first light-emitting element in an element group numbered 1 is electrically connected to the driving voltage terminal; a first light-emitting element in an element group numbered k is electrically connected to a first light-emitting element in an element group numbered k+1 through the first connection line; where 1<k<M and k is an integer; a last light-emitting element in an element group numbered M is electrically connected to the output terminal; and one column of light-emitting cells corresponds to one common voltage line, and the one common voltage line is located between the element group numbered k and the element group numbered k+1 in the one column of light-emitting cells.

In some examples, the second conductive layer further includes a plurality of series wires arranged at intervals; the light-emitting elements in the same element group are electrically connected in series through the series wire; and a last light-emitting element in the element group numbered k-1 is electrically connected to a last light-emitting element in the element group numbered k through the series wire; and orthographic projections of the plurality of common voltage lines on the base substrate do not overlap with orthographic projections of the plurality of series wires on the base substrate.

In some examples, the light-emitting substrate further includes a fan-out area; the first conductive layer further includes a plurality of first fan-out lines and a plurality of second connection lines in the fan-out area; where one of the plurality of common voltage lines is electrically connected to one of the plurality of first fan-out lines; the first fan-out line includes a first sub-fan-out line and a second sub-fan-out line; the first sub-fan-out line extends along the first direction; and the second sub-fan-out line extends along the second direction; the second conductive layer further includes a plurality of second bridge portions in the fan-out area; the first sub-fan-out line includes a plurality of first fan-out line segments arranged at intervals; in a same first sub-fan-out line, two adjacent first fan-out line segments are electrically connected through the second bridge portion, and at least one second connection line is at a gap between the two adjacent first fan-out line segments; and at the gap between the two adjacent first fan-out line segments in the first sub-fan-out line, an orthographic projection of the second bridge portion on the base substrate overlaps with an orthographic projection of the second connection line on the base substrate.

In some examples, the first conductive layer further includes a plurality of third connection lines; the second conductive layer further includes a plurality of third bridge portions in the fan-out area; the second sub-fan-out line includes a plurality of second fan-out line segments arranged at intervals; in a same second sub-fan-out line, two adjacent second fan-out line segments are electrically connected through the third bridge portion, at least one third connection line is at a gap between the two adjacent second fan-out line segments; and at the gap between the two adjacent second fan-out line segments in the second sub-fan-out line, an orthographic projection of the third bridge portion on the base substrate overlaps with an orthographic projection of the third connection line on the base substrate.

In some examples, the fan-out area includes a plurality of light-emitting cells, and each of the plurality of the light-emitting cells includes a driving circuit and a plurality of light-emitting elements; where the driving circuit includes a common voltage terminal and an output terminal; and the plurality of light-emitting elements are sequentially connected in series between a driving voltage terminal and the output terminal; the common voltage terminal is electrically connected to the first fan-out line; and in at least one of the plurality of light-emitting cells, at least two of the plurality of light-emitting elements are electrically connected through the second connection line; and/or, at least two of the plurality of light-emitting elements are electrically connected through the third connection line.

A display apparatus provided by embodiments of the present disclosure includes the above-mentioned light-emitting substrate.

### Brief Description of Figures

Fig. 1A is a schematic structural diagram of a light-emitting substrate in the related art.
Fig. 1B is a schematic diagram of a partial layout of a light-emitting substrate in the related art.
Fig. 2 is a schematic structural diagram of a light-emitting substrate according to embodiments of the present disclosure.
Fig. 3 is a schematic diagram of a partially specific structure of a light-emitting substrate according to embodiments of the present disclosure.
Fig. 4 is a waveform diagram of a second input signal in a driving circuit according to embodiments of the present disclosure.
Fig. 5 is a signal timing diagram of a driving circuit according to embodiments of the present disclosure.
Fig. 6 is a schematic diagram of a partial layout of a light-emitting substrate according to embodiments of the present disclosure.
Fig. 7 is a schematic diagram of an enlarged layout of a FB area in Fig. 6.
Fig. 8A is a schematic diagram of a cross-sectional structure along an AA' direction in Fig. 7.
Fig. 8B is a schematic diagram of a cross-sectional structure along a BB' direction in Fig. 7.
Fig. 9 is a schematic diagram of a partial layout of a fan-out area according to embodiments of the present disclosure.

### Detailed Description

In order to make objectives, technical solutions and advantages of embodiments of the present disclosure clearer, technical solutions in the embodiments of the present disclosure will be clearly and completely described below in combination with accompanying drawings in the embodiments of the present disclosure. Apparently, the described embodiments are merely some embodiments rather than all embodiments of the present disclosure. In addition, embodiments of the present disclosure and features in the embodiments can be combined with each other without conflict. On the basis of the described embodiments of the present disclosure, all other embodiments obtained by those of ordinary skill in the art without making creative efforts all fall within the scope of protection of the present disclosure.

Unless otherwise defined, technical terms or scientific terms used in the present disclosure should have ordinary meanings understandable by a person of ordinary skill in the field to which the present disclosure belongs. Words such as "first" and "second" used in the present disclosure do not denote any order, quantity, or importance, but are merely used to distinguish between different components. Words such as "comprise", "include" or "encompass" are intended to mean that an element or item in front of the word encompasses elements or items that are present behind the word and it equivalents, but does not exclude other elements or items. Words such as "connection" and "connected" are not limited to physical or mechanical connections, but can include an electrical connection that is direct or indirect.

It should be noted that a size and a shape of each figure in the accompanying drawings do not reflect true scales, and are merely intended to illustrate contents of the present disclosure. Identical or similar reference numerals denote identical or similar elements or elements having identical or similar functions throughout.

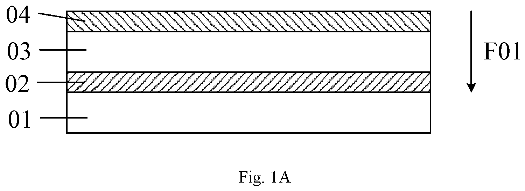

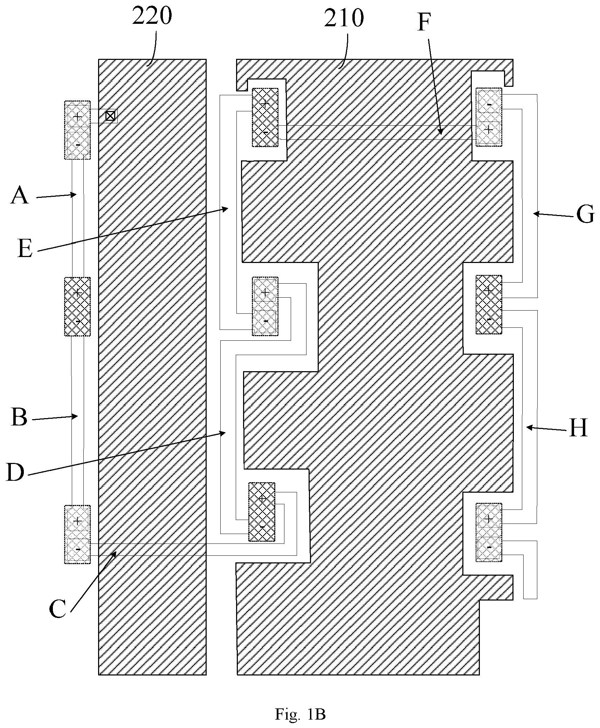

Referring to Fig. 1A and Fig. 1B, a first conductive layer 02, an insulating layer 03 and a second conductive layer 04 are sequentially located on a base substrate 01. The first conductive layer 02 is provided with a driving voltage line 220 and a common voltage line 210. The second conductive layer 04 is provided with metal connecting lines. Taking one light-emitting cell having 9 light-emitting elements as an example, the 9 light-emitting elements are electrically connected in series through the metal connecting lines. A metal connecting line among the 9 light-emitting elements are divided into 8 segments: segment A, segment B, segment C, segment D, segment E, segment F, and segment G. For example, a voltage transmitted on the driving voltage line 220 is 27V, a voltage transmitted on the common voltage line 210 is 0V, a voltage transmitted on the metal connecting line of segment A is 24V, a voltage transmitted on the metal connecting line of segment B is 21V, and a voltage transmitted on the metal connecting line of segment C is 18V, a voltage transmitted on the metal connecting line of segment D is 15V, a voltage transmitted on the metal connecting line of segment E is 12V, a voltage transmitted on the metal connecting line of segment F is 9V, a voltage transmitted on the metal connecting line of segment G is 6V, and a voltage transmitted on the metal connecting line of segment H is 3V. In addition, an orthographic projection of the metal connecting line of segment C on the base substrate overlaps with an orthographic projection of the driving voltage line 220 on the base substrate, and an orthographic projection of the metal connecting line of segment F on the base substrate overlaps with an orthographic projection of the common voltage line 210 on the base substrate.

Since the voltage transmitted on the metal connecting line of segment F is greater than the voltage transmitted on the common voltage line 210, a direction of an electric field at the overlap of the metal connecting line of segment F and the common voltage line 210 points from the second conductive layer to the first conductive layer. Since the second conductive layer is easily exposed and easily absorbs water and oxygen, and the material of the first conductive layer 02 and the second conductive layer 04 is generally a Cu material with a low resistance. Since the Cu material is relatively active, it is easy to cause metal corrosion under the action of an electric field. There is an electric potential difference between the metal connecting line of segment F and the common voltage line 210, forming an anode and a protective cathode of electrochemical corrosion. The metal connecting line of segment F is a positive electrode for oxidation reaction, and the common voltage line 210 is a cathode for reduction reaction. The continuous progress of electrochemical corrosion eventually leads to a short circuit between the metal connecting line of segment F and the common voltage line 210. However, if there is the electrochemical corrosion in the light-emitting substrate, it will affect the light-emitting stability of the light-emitting substrate.

Moreover, since the voltage transmitted on the metal connecting line of segment C is less than the voltage transmitted on the driving voltage line 220, a direction of an electric field at the overlap of the metal connecting line of segment C and the driving voltage line 220 points from the first conductive layer to the second conductive layer. The driving voltage line 220 is protected by the insulating layer 03, and an intrusion path of water and oxygen is relatively far, so the situation of electrochemical corrosion can be reduced. In view of this, at least one embodiment of the present disclosure provides a light-emitting substrate and a display apparatus, which can reduce the influence of electrochemical corrosion on the light-emitting substrate and improve light-emitting stability.

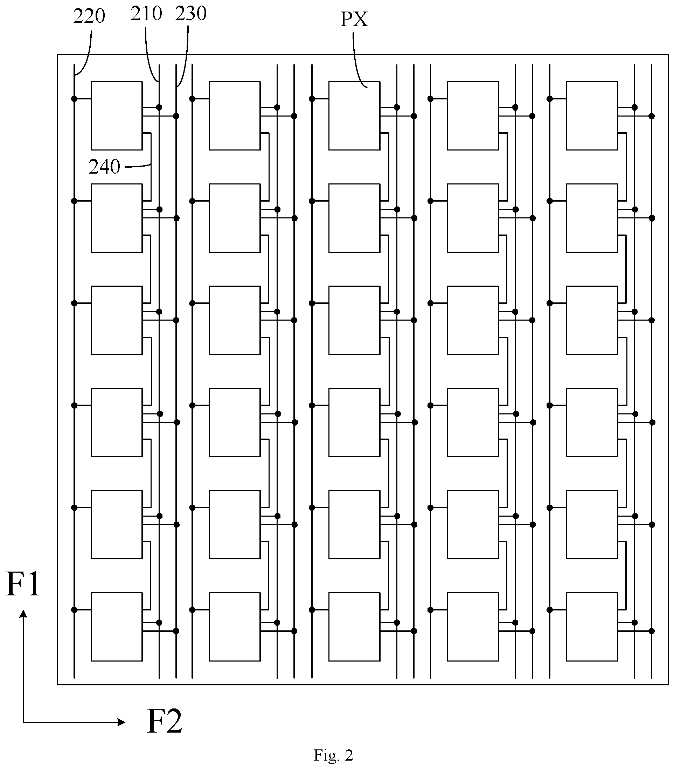

In some embodiments, as shown in Fig. 2, the light-emitting substrate according to at least one embodiment of the present disclosure may include a base substrate 10. The base substrate 10 may include a display area and a fan-out area FO. Exemplarily, the material of the base substrate 10 may be from plastics, polyimide, silicon, ceramics, glass, quartz, etc., which is not limited in the embodiments of the present disclosure.

In some embodiments, as shown in Fig. 2, the display area may include a plurality of light-emitting cells PX arranged in an array. For example, the plurality of light-emitting cells PX are arranged in multiple rows and multiple columns. In practical applications, the number of light-emitting cells PX may be determined according to actual needs, for example, according to a size of the light-emitting substrate and the required brightness. Although only 6 rows and 5 columns of light-emitting cells PX are shown in Fig. 2, it should be understood that, the number of light-emitting cells PX is not limited to this.

In some embodiments, as shown in Fig. 2, in the display area, the light-emitting cells PX may be arranged in multiple rows and multiple columns along a first direction F1 and a second direction F2. Exemplarily, the light-emitting substrate is a rectangular in shape, the first direction F1 may be a direction parallel to a long side of the light-emitting substrate, and the second direction F2 may be a direction parallel to a short side of the light-emitting substrate. Or, the first direction F1 may be a direction parallel to a short side of the light-emitting substrate, and the second direction F2 may be a direction parallel to a long side of the light-emitting substrate. Of course, the embodiments of the present disclosure are not limited to this. The first direction F1 and the second direction F2 may be any directions, as long as the first direction F1 and the second direction F2 intersect. Moreover, the plurality of light-emitting cells PX are not limited to being arranged in a straight line, and may also be arranged in a zigzag line, in a ring, or in any manner, which may be determined according to actual needs, and the embodiments of the present disclosure are not limited to this.

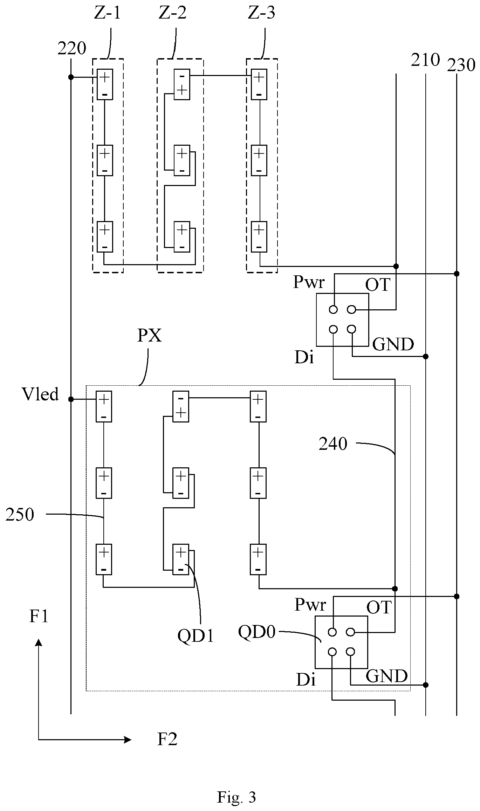

In some embodiments, as shown in Fig. 2 and Fig. 3, each light-emitting cell PX may include a driving circuit QD0 and a plurality of light-emitting elements QD1. Exemplarily, the driving circuit QD0 may include a first input terminal Di, a second input terminal Pwr, an output terminal OT and a common voltage terminal GND. Moreover, a plurality of light-emitting elements QD1 in the light-emitting cell PX are sequentially connected in series, and are electrically connected between the driving voltage terminal Vied and the output terminal OT of the driving circuit QD0. Of course, the plurality of light-emitting elements QD1 in the light-emitting cell PX may also be connected in parallel to be electrically connected between the driving voltage terminal Vied and the output terminal OT of the driving circuit QD0. Or, the plurality of light-emitting elements QD1 in the light-emitting cell PX may also be connected in series after part of the light-emitting elements QD 1 in the light-emitting cell PX is connected in parallel, so as to be electrically connected between the driving voltage terminal Vied and the output terminal OT of the driving circuit QD0. In practical applications, it may be designed according to actual needs, which is not limited here.

In some examples, during specific implementation, the driving circuit QD0 may be configured to output a relay signal through the output terminal OT within a first time duration according to a first input signal received by the first input terminal Di and a second input signal received by the second input terminal Pwr and form a current pathway with the light-emitting elements QD1 connected in series through the output terminal OT. Exemplarily, the first input terminal Di receives a first input signal, such as an address signal, for gating the driving circuit QD0 of the corresponding address. For example, addresses of different driving circuits QD0 may be the same or different. The first input signal may be an 8-bit address signal, and the address to be transmitted may be obtained by parsing the address signal. The second input terminal Pwr receives a second input signal, such as a power line carrier communication signal. For example, the second input signal not only provides electric energy for the driving circuit QD0, but also transmits communication data to the driving circuit QD0. The communication data may be used for controlling a light-emitting duration of the corresponding light-emitting cell PX, and further controlling visual light-emitting brightness. The output terminal OT may output different signals in different time durations, such as outputting a relay signal and a driving signal respectively. For example, the relay signal is an address signal provided to other driving circuit QD0, that is, the first input terminal Di of other driving circuit QD0 receives the relay signal as a first input signal, to obtain the address signal. For example, the driving signal may be a driving current for driving the light-emitting element QD1 to emit light. The common voltage terminal GND receives a common voltage signal, such as a ground signal.

The driving circuit QD0 is configured to output a relay signal through the output terminal OT within a first time duration according to a first input signal received by the first input terminal Di and a second input signal received by the second input terminal Pwr and provide a driving signal to a plurality of light-emitting elements QD 1 connected in series through the output terminal OT within a second time duration. Within the first time duration, the output terminal OT outputs the relay signal, and the relay signal is provided to other driving circuit QD0, so that other driving circuit QD0 obtains an address signal. Within the second time duration, the output terminal OT outputs a driving signal, which is provided to a plurality of light-emitting elements QD1 connected in series, so that the light-emitting elements QD1 emit light within the second time duration. For example, the first time duration and the second time duration are different time durations, for example, the first time duration may be earlier than the second time duration. The first time duration may be continuous with the second time duration, and an end time of the first time duration is a start time of the second time duration; or, there may be other time durations between the first time duration and the second time duration. Other time durations may be used for realizing other required functions; or, other time durations may also be used only for separating the first time duration from the second time duration, so as to prevent signals of the output terminal OT during the first time duration and the second time duration from interfering with each other.

It should be noted that, when the driving signal is a driving current, the driving current may flow from the output terminal OT to the light-emitting element QD1, or flow from the light-emitting element QD1 to the output terminal OT; and the flow direction of the driving current may be determined according to actual needs, which is not limited in the embodiments of the disclosure. In the disclosure, outputting a driving signal by the output terminal OT means that the output terminal OT provides a driving signal, and the direction of the driving signal may either flow out from the output terminal OT or flow into the output terminal OT.

A mini light-emitting diode (mini-LED) or micro light-emitting diode (micro-LED) is small in size and high in brightness, and may be widely used in display apparatuses or backlight modules of the display apparatuses. Through fine adjustment of backlight, display of high-dynamic range (HDR) images is realized. For example, a typical size (such as a length) of a micro-LED is less than 100 microns, such as in a range of 10 microns to 80 microns; and a typical size (such as a length) of a mini-LED ranges from 80 microns to 350 microns, such as 80 microns to 120 microns. Exemplarily, the light-emitting element QD1 may be a micro-LED or a mini-LED.

For example, each light-emitting element QD1 includes a positive electrode (+) and a negative electrode (-) (or, also called an anode and a cathode), and positive electrodes and negative electrodes of a plurality of light-emitting elements QD1 are sequentially connected in series from end to end, so that a current flow path is formed between the driving voltage terminal Vied and the output terminal OT. Moreover, the driving voltage terminal Vled may provide a driving voltage, for example, the driving voltage is a high voltage during a time duration (a second time duration) in which the light-emitting elements QD1 need to emit light, and a low voltage during other time durations. Therefore, within the second time duration, the driving signal (such as a driving current) flows from the driving voltage terminal Vied through the plurality of light-emitting elements QD1 sequentially into the output terminal OT of the driving circuit QD0. The plurality of light-emitting elements QD1 emit light when the driving current flows through them, and by controlling the duration of the driving current, the light-emitting duration of the light-emitting elements QD1 can be controlled, so as to control the visual brightness of light.

In some examples, as shown in Fig. 2 and Fig. 3, the light-emitting cell PX may include 9 light-emitting elements QD1 arranged in 3 rows and 3 columns. Exemplarily, when the 9 light-emitting elements QD1 are connected in series, a light-emitting element QD1 electrically connected to the driving voltage terminal Vled serves as a start point of the 9 light-emitting elements QD1 connected in series, and a light-emitting element QD1 electrically connected to the output terminal OT of the driving circuit QD0 serves as an end point of the 9 light-emitting elements QD1 connected in series. Moreover, the driving voltage terminal Vied can be electrically connected to the positive electrode of the light-emitting element QD1, and the output terminal OT of the driving circuit QD0 can be electrically connected to the negative electrode of the light-emitting element QD1. By adopting such a distribution mode and a series connection mode, overlap of traces can be effectively avoided, and design and preparation are facilitated. Moreover, lengths of the signal lines between any two adjacent light-emitting elements QD1 on the series circuit can be set approximately the same, so that resistances of the signal lines themselves are relatively balanced, which can improve load balance and circuit stability.

It should be noted that, in the embodiments of the present disclosure, the number of light-emitting elements QD1 in each light-emitting cell PX is not limited, and may be 6, 8, or 12, etc., but is not limited to 9. The plurality of light-emitting elements QD1 may be arranged in any arrangement mode, for example, the plurality of light-emitting elements QD1 may be arranged in a required pattern, and not limited to a matrix arrangement. Moreover, a set position of the driving circuit QD0 is not limited, and the driving circuit QD0 may be arranged at any gap between the light-emitting elements QD1, which can be determined according to actual needs and is not limited by the embodiments of the present disclosure.

In some examples, in specific implementation, as shown in Fig. 2 and Fig. 3, relative positions of driving circuits QD0 in the light-emitting cells PX may be different or the same. The relative positional relationships of the light-emitting elements QD1 in light-emitting cells PX may be the same. For example, the relative positional relationship of the light-emitting elements QD1 in one light-emitting cell PX may be used as a reference, and light-emitting elements QD1 are periodically and repeatedly arranged along the first direction F1 and the second direction F2. For example, for the plurality of light-emitting cells PX arranged in the first direction F1, light-emitting elements QD1 located at the same position in respective light-emitting cells PX may be arranged substantially in the same straight line along the first direction F1. For the plurality of light-emitting cells PX arranged in the second direction F2, the light-emitting elements QD 1 located at the same position in respective light-emitting cells PX may be arranged substantially in the same straight line along the second direction F2.

In some examples, during specific implementation, the driving circuit QD0 may include a demodulation circuit, a physical layer interface circuit, a data processing control circuit, a pulse width modulation circuit, a driving signal generation circuit, a relay signal generation circuit and a power supply circuit.

Exemplarily, the demodulation circuit is electrically connected to the second input terminal Pwr and the physical layer interface circuit, is configured to demodulate the second input signal to obtain communication data, and transmit the communication data to the physical layer interface circuit. For example, a second input signal input to the second input terminal Pwr is a power line carrier communication signal, and the power line carrier communication signal includes information corresponding to the communication data. For example, the communication data is data reflecting a light-emitting duration, and further indicates the light-emitting brightness required. Compared with the usual serial peripheral interface (SPI) protocol, in the embodiments of the present disclosure, the power line carrier communication (PLC) protocol is adopted to superimpose the communication data on a power signal, thereby effectively reducing the number of signal lines.

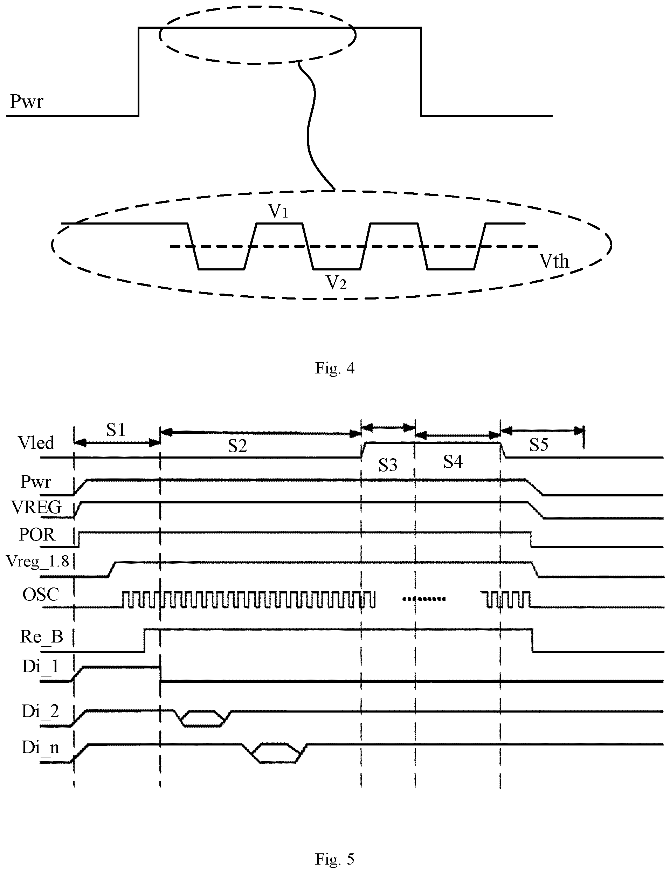

As shown in Fig. 4, a dotted ellipse indicates an enlarged view of a corresponding waveform. When the second input signal is a high level, an amplitude of the high level fluctuates around a threshold amplitude Vth, for example, the amplitude of the high level varies between a first amplitude V1 and a second amplitude V2, where V2<Vth<V1. By modulating a change rule of the first amplitude V1 and the second amplitude V2, the communication data may be modulated into the second input signal, so that the second input signal transmits information corresponding to the communication data while transmitting electric energy. For example, the demodulation circuit filters out a direct-current (DC) power component of the second input signal, to obtain the communication data. The detailed description of the second input signal may refer to the conventional power line carrier communication signal, which will not be described in detail here. Correspondingly, the detailed description of the demodulation circuit can also refer to a demodulation circuit of the conventional power line carrier communication signal, which will not be described in detail here.

Exemplarily, the physical layer interface circuit is also electrically connected to the data processing control circuit, and is configured to process the communication data to obtain data frames (such as, frame frequency data), and transmit the data frames to the data processing control circuit. The data frames obtained by the physical layer interface circuit contains information that needs to be transmitted to the driving circuits QD0, such as information related to the light-emitting time (such as, a specific duration of the light-emitting time). For example, the physical layer interface circuit may be a common port physical layer (PHY), and the detailed description may refer to conventional design, which will not be described in detail here.

Exemplarily, the data processing control circuit is also electrically connected to the first input terminal Di, the pulse width modulation circuit and the relay signal generation circuit. The data processing control circuit is configured to generate a pulse width control signal based on the data frames and transmit the pulse width control signal to the pulse width modulation circuit, and is configured to generate a relay control signal based on the first input signal and transmit the relay control signal to the relay signal generation circuit. For example, according to the data frames, the required light-emitting duration of the light-emitting element QD1 connected to the driving circuit QD0 may be obtained, so that a corresponding pulse width control signal is generated based on the light-emitting duration. For example, after the data processing control circuit processes the first input signal, the data processing control circuit generates the relay control signal is a signal. By processing (such as parsing, latching, decoding, etc.) the first input signal, an address signal corresponding to the driving circuit QD0 may be obtained, and a relay control signal corresponding to the subsequent address will be generated. The subsequent address corresponds to other driving circuit QD0. For example, the data processing control circuit may be implemented as a single-chip microcomputer, a central processing unit (CPU), a digital signal processor, and the like.

Exemplarily, the pulse width modulation circuit is also electrically connected to the driving signal generation circuit, and is configured to generate a pulse width modulation signal in response to the pulse width control signal, and transmit the pulse width modulation signal to the driving signal generation circuit. For example, the pulse width modulation signal generated by the pulse width modulation circuit corresponds to the required light-emitting duration of the light-emitting element QD1, for example, the effective pulse width duration is equal to the required light-emitting duration of the light-emitting element QD1. For example, the detailed description of the pulse width modulation circuit may refer to the conventional pulse width modulation circuit, which will not be described in detail here.

Exemplarily, the driving signal generation circuit is further electrically connected to the output terminal OT, and is configured to generate a driving signal in response to the pulse width modulation signal, and output the driving signal from the output terminal OT. Here, outputting the driving signal from the output terminal OT may mean that the driving signal (such as the driving current) flows from the output terminal OT to the light-emitting element QD1, or the driving signal (such as the driving current) flows from the light-emitting element QD1 to the output terminal OT; and the specific direction of current flow is not limited.

Exemplarily, in some examples, when the driving signal is a driving current, the driving signal generation circuit may include a current source and a metal oxide semiconductor (MOS) field effect transistor (FET), and the MOSFET is called an MOS transistor. A control electrode of the MOS transistor receives the pulse width modulation signal transmitted by the pulse width modulation circuit, and thus is turned on or turned off under the control of the pulse width modulation signal. A first electrode of the MOS transistor is connected to the output terminal OT, a second electrode of the MOS transistor is connected to a first electrode of the current source, and a second electrode of the current source is connected to the common voltage terminal GND to receive the common voltage. For example, the current source may be a constant current source.

When the pulse width modulation signal is an active level, the MOS transistor is turned on, and the current source provides a driving current through the output terminal OT. When the pulse width modulation signal is an inactive level, the MOS transistor is turned off, and the output terminal OT does not provide a driving current in this case. The duration of the active level of the pulse width modulation signal is equal to the on duration of the MOS transistor, and the on duration of the MOS transistor is equal to the duration of the driving current provided by the output terminal OT. Therefore, the light-emitting duration of the light-emitting elements QD1 may be further controlled, and the visual light-emitting brightness may be further controlled. For example, in some examples, when the MOS transistor is turned on, the driving current flows into the driving circuit QD0 from the OT terminal, flows through the MOS transistor and the current source in turn, and then flows into the ground terminal (such as the common voltage terminal GND). It should be noted that, in the embodiments of the present disclosure, the driving signal generation circuit may also adopt other circuit structures, which are not limited in the embodiments of the present disclosure.

Exemplarily, the relay signal generation circuit is further electrically connected to the output terminal OT; and is configured to generate a relay signal based on the relay control signal, and output the relay signal from the output terminal OT. For example, the relay control signal corresponds to a subsequent address, the relay signal generated based on the relay control signal includes the subsequent address, and the subsequent address corresponds to other driving circuit QD0. After the relay signal is output from the output terminal OT, the relay signal is provided to a first input terminal Di of a driving circuit QD0 provided separately, and the relay signal serves as the first input signal to be input to the driving circuit QD0 provided separately, so that the driving circuit QD0 provided separately obtains the corresponding address signal. The relay signal generation circuit may be implemented by a latch, a decoder, an encoder, etc., which is not limited in the embodiments of the present disclosure.

It should be noted that, in the embodiments of the present disclosure, although both the driving signal generation circuit and the relay signal generation circuit are electrically connected to the output terminal OT, the driving signal generation circuit and the relay signal generation circuit respectively output the driving signal and the relay signal during different time durations, and the driving signal and the relay signal are time-divisionally transmitted through the output terminal OT, so they will not affect each other.

Exemplarily, the power supply circuit is electrically connected to the demodulation circuit and the data processing control circuit respectively, and is configured to receive electric energy and supply power to the data processing control circuit. For example, the second input signal is a power line carrier communication signal. After the second input signal is demodulated by the demodulation circuit, the DC power component (that is, electric energy) in the second input signal is transmitted to the power supply circuit, and then provided to the data processing control circuit by the power supply circuit. Certainly, the embodiments of the present disclosure are not limited to this, and the power supply circuit may also be electrically connected with other circuits in the driving circuit QD0 to provide electric energy. The power supply circuit may be realized by a switch circuit, a voltage conversion circuit, a voltage stabilization circuit, etc., which are not limited in the embodiments of the present disclosure.

It should be noted that, in the embodiments of the present disclosure, the driving circuit QD0 may also include more circuits and components, and is not limited to the above-mentioned demodulation circuit, the physical layer interface circuit, the data processing control circuit, the pulse width modulation circuit, the driving signal generation circuit, the relay signal generation circuit and the power supply circuit, which may be determined according to functions to be realized, and are not limited in the embodiments of the present disclosure.

As shown in Fig. 5, when the driving circuit QD0 starts to work, the driving circuit QD0 is first powered on to complete the initialization, and then the address writing operation is performed in a time duration S1, that is, in the time duration S1, a first input signal Di_1 is input to the driving circuit QD0 through the first input terminal Di, thereby an address is written in. For example, the first input signal Di_1 is transmitted through a separately provided transmitter.

Next, in a time duration S2, driving configuration is performed, and a relay signal Di_2 is output through the output terminal OT. For example, the relay signal Di_2 serves as the first input signal to be input to a first input terminal Di of a driving circuit QD0 provided separately. For example, the aforementioned first time duration is the time duration S2.

Then, in a time duration S3, the driving voltage terminal Vied is powered on. For example, after the plurality of driving circuits QD0 obtain the corresponding addresses, the time duration S3 is entered after about 10 microseconds. At this moment, a driving voltage provided by the driving voltage terminal Vied becomes a high level.

Next, in a time duration S4, the driving circuit QD0 is in the normal operation, and the output terminal OT provides a driving signal (such as a driving current) according to the required duration, so that the light-emitting elements QD1 connected to the driving circuit QD0 emits light according to the required duration. For example, the aforementioned second time duration is the time duration S4. For example, in a case of serving as a backlight unit of a display apparatus, the light-emitting substrate using the driving circuit QD0 works in a local backlight adjustment (local dimming) mode, which can achieve a high dynamic range effect.

Finally, in a time duration S5, the system is shut down, that is, the driving circuit QD0 is powered off, the driving voltage provided by the driving voltage terminal Vied becomes a low level, and the light-emitting elements QD1 stop emitting light.

It should be noted that the above working process is only illustrative and not limited, and the actual working process of the driving circuit QD0 may be determined according to actual needs, which is not limited by the embodiments of the present disclosure. In Fig. 5, VREG, POR, Vreg_1.8, OSC, and Re_B are all internal signals of the driving circuit QD0, and will not be input or input through the first input terminal Di, the second input terminal Pwr, the output terminal OT, and the common voltage terminal GND. Di_1 is the first input signal received by the driving circuit QD0, Di_2 is the relay signal (that is, the first input signal received by the next connected driving circuit QD0) output by the driving circuit QD0, and Di_n is the first input signal received by the n^{th} driving circuit QD0 in the plurality of driving circuits QD0 connected sequentially.

Exemplarily, during specific implementation, the driving circuit QD0 may be configured as a chip, a size (for example, a length) of the chip may be tens of microns, and an area of the chip is about hundreds of square microns or even smaller, which is similar to a size of mini-LED. The driving circuit QD0 has the characteristic of miniaturization, which is easy to be integrated into the light-emitting substrate (for example, bonded to the surface of the light-emitting substrate), saves the installation space of a printed circuit board, simplifies a structure, and is conducive to realizing light weight and thin. Each driving circuit QD0 directly drives one light-emitting cell PX, which avoids a problem of the complicated operation and being easy flickering in the row scanning control mode. Moreover, the number of ports of the driving circuit QD0 is small, the number of required signals is small, the control mode is simple, a wire routing mode is simple, and the cost is low.

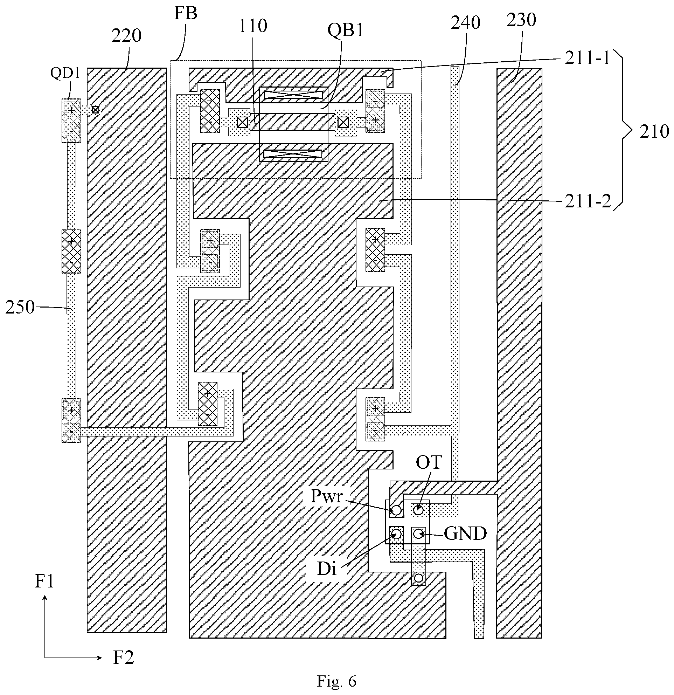

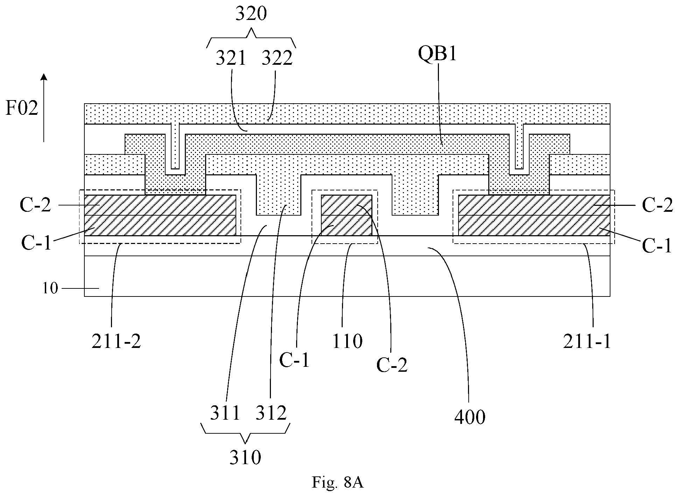

During specific implementation, in the embodiments of the present disclosure, as shown in Fig. 6 to Fig. 8B, a buffer layer 400 is located on the base substrate 10 to improve the adhesion force for the first conductive layer. The first conductive layer is located on a side, away from the base substrate 10, of the buffer layer 400. Exemplarily, the first conductive layer may include: a plurality of common voltage lines 210, a plurality of driving voltage lines 220, a plurality of source voltage lines 230 and a plurality of first connection lines 110 arranged at intervals. Exemplarily, one column of light-emitting cells PX may correspond to one common voltage line 210, one source voltage line 230 and one driving voltage line 220. For one column of light-emitting cells PX corresponding to the common voltage line 210, the source voltage line 230 and the driving voltage line 220, an orthographic projection of the common voltage line 210 on the base substrate 10 is located between the driving voltage line 220 and the source voltage line 230.

Exemplarily, the plurality of driving voltage lines 220 extend along the first direction F1 and are arranged along the second direction F2. One column of light-emitting cells PX may correspond to one driving voltage line 220, so that the driving voltage terminal Vied of the one column of light-emitting cells PX is electrically connected to a corresponding driving voltage line 220. For example, as shown in Fig. 3, when the 9 light-emitting elements QD1 are connected in series, a light-emitting element QD1 electrically connected to the driving voltage line 220 serves as a start point of the 9 light-emitting elements QD 1 connected in series.

Exemplarily, the plurality of source voltage lines 230 extend along the first direction F1 and are arranged along the second direction F2. The source voltage line 230 may be electrically connected to the second input terminal Pwr of the driving circuit QD0. In this way, the second input signal may be transmitted to the second input terminal Pwr of the driving circuit QD0 through the source voltage line 230.

Exemplarily, the plurality of common voltage lines 210 extend along the first direction F1 and are arranged along the second direction F2. In some examples, the common voltage terminal may be electrically connected to the common voltage line 210 to provide a voltage to the common voltage terminal of the driving circuit QD0 through the common voltage line 210.

It should be noted that, by arranging extension directions of most of the signal lines in the first conductive layer to be the same, the wiring space may be reasonably designed and signal interference may be reduced.

Exemplarily, one column of light-emitting cells PX corresponds to one common voltage line 210 and one driving voltage line 220. That is, common voltage terminals GND of driving circuits QD0 in one column of light-emitting cells PX are all electrically connected to the same common voltage line 210, and driving voltage terminals Vied of one column of light-emitting cells PX are all electrically connected to the same driving voltage line 220.

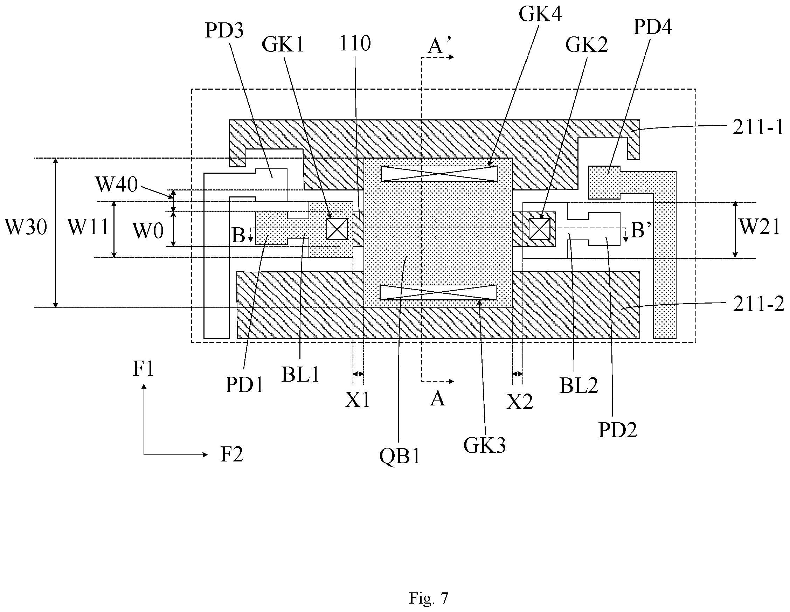

In some examples, during specific implementation, as shown in Fig. 6 and Fig. 7, for a common voltage line 210, a driving voltage line 220 and a source voltage line 230 corresponding to one column of light-emitting cells PX, the common voltage line 210 is between the driving voltage line 220 and the source voltage line 230. Exemplarily, a width of the common voltage line 210 in the second direction F2 is greater than a width of the driving voltage line 220 in the second direction F2. The width of the driving voltage line 220 in the second direction F2 is greater than a width of the source voltage line 230 in the second direction F2. The width of the source voltage line 230 in the second direction F2 is greater than a width of a cascaded wire 240 in the second direction F2.

In some examples, the first conductive layer may use a metal material to form a single-layer structure. Or, the first conductive layer may also use metal materials to form a laminated structure. For example, the first conductive layer is formed by using two layers of metal materials, for example, the first conductive layer includes a C-1 layer and a C-2 layer. Exemplarily, metal materials may include but is not limited to Cu.

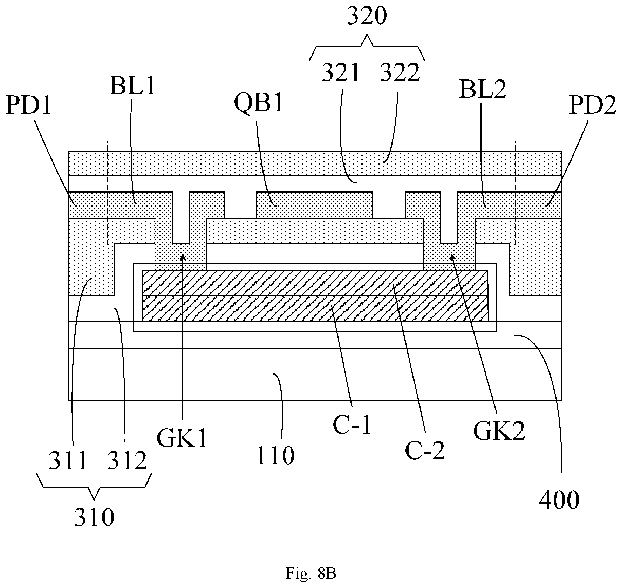

During specific implementation, in the embodiments of the present disclosure, a first insulating layer 310 is formed on the first conductive layer, that is, the first insulating layer 310 is located on a side, away from the base substrate 10, of the first conductive layer. Moreover, the first insulating layer 310 is provided with a first via hole GK1, a second via hole GK2, a third via hole GK3, and a fourth via hole GK4. Exemplarily, the first insulating layer 310 may be a single-layer structure formed by using inorganic, organic or organic-inorganic composite materials. Or, the first insulating layer 310 may also be a multi-layer structure formed by using at least one of inorganic, organic or organic-inorganic composite materials. For example, the first insulating layer 310 may be formed by using multiple layers of organic materials. The first insulating layer 310 may also be formed by using multiple layers of inorganic materials. The first insulating layer 310 may also be formed by stacking the organic material and the inorganic material. Exemplarily, as shown in Fig. 8A and Fig. 8B, the first insulating layer 310 may include an insulating layer 311 and an insulating layer 312. The material of the insulating layer 312 may be an organic material, and the material of the insulating layer 311 may be an inorganic material.

Exemplarily, the inorganic material may be selected from at least one of silicon nitride (SiNx), silicon oxide (SiOx), silicon oxynitride (SiON), and the like. The organic material may be polyimide (PI), etc.

In some examples, during specific implementation, as shown in Figs. 6 to 8B, a second conductive layer is formed on the first insulating layer 310, that is, the second conductive layer is located on a side, away from the base substrate 10, of the first insulating layer 310. Exemplarily, the second conductive layer may include: a plurality of pads (such as PD1, PD2, PD3, PD4), and a plurality of cascaded wires 240 arranged at intervals. Exemplarily, the plurality of cascaded wires 240 extend along the first direction F1. For example, along the first direction F1, the driving circuits QD0 in one column of light-emitting cells PX may be coupled to each other, and the driving circuits QD0 in adjacent light-emitting cells PX in one column of light-emitting cells PX are coupled through the cascaded wire 240. For example, along a direction indicated by an arrow in the first direction F1, first to sixth rows are defined. Along a direction indicated by an arrow in the second direction F2, first to fifth columns are defined. Taking the first column as an example, an output terminal of a driving circuit QD0 in the first row of light-emitting cells PX is coupled to a first input terminal Di of a driving circuit QD0 in the second row of light-emitting cells PX through one cascaded wire 240. An output terminal of the driving circuit QD0 in the second row of light-emitting cells PX is coupled to a first input terminal Di of a driving circuit QD0 in the third row of light-emitting cells PX through one cascaded wire 240. An output terminal of a driving circuit QD0 in the third row of light-emitting cells PX is coupled to a first input terminal Di of a driving circuit QD0 in the fourth row of light-emitting cells PX through one cascaded wire 240. An output terminal of the driving circuit QD0 in the fourth row of light-emitting cells PX is coupled to a first input terminal Di of a driving circuit QD0 in the fifth row of light-emitting cells PX through one cascaded wire 240. An output terminals of the driving circuit QD0 in the fifth row of light-emitting cells PX is coupled to a first input terminal Di of a driving circuit QD0 in the sixth row of light-emitting cells PX through one cascaded wire 240. An output terminal of the driving circuit QD0 in the sixth row of light-emitting cells PX is coupled to a cascaded output terminal through one cascaded output wire. In this way, the cascaded wires 240 and the cascaded driving circuits QD0 have the same direction, reducing a signal overlapping area and signal interference.

During specific implementation, in the embodiments of the present disclosure, pads may be electrically connected to the driving circuit. For example, pads are electrically connected with corresponding pins in the driving circuit for signal transmission.

During specific implementation, in the embodiments of the present disclosure, as shown in Fig. 6 and Fig. 7, pads may also be electrically connected to the light-emitting element. For example, each electrode of the light-emitting element is electrically connected to one pad correspondingly. For example, a pad PD3 is electrically connected to a positive electrode of a light-emitting element QD1, and a pad PD1 is electrically connected to a negative electrode of the light-emitting element QD1. A pad PD2 is electrically connected to a positive electrode of a light-emitting element QD1, and a pad PD4 is electrically connected to a negative electrode of the light-emitting element QD1. The rest can be deduced in the same way, and will not be repeated here.

During specific implementation, in the embodiments of the present disclosure, a second insulating layer 320 is formed on the second conductive layer, that is, the second insulating layer 320 is on a side, away from the base substrate 10, of the second conductive layer. Exemplarily, the second insulating layer 320 may be a single-layer structure formed by using inorganic, organic or organic-inorganic composite materials. Or, the second insulating layer 320 may also be a multi-layer structure formed by using at least one of inorganic, organic or organic-inorganic composite materials. For example, the second insulating layer 320 may be formed by using multiple layers of organic materials. The second insulating layer 320 may also be formed by using multiple layers of inorganic materials. The second insulating layer 320 may also be formed by stacking the organic material and the inorganic material. Exemplarily, as shown in Fig. 8A and Fig. 8B, the second insulating layer 320 may include an insulating layer 321 and an insulating layer 322. The material of the insulating layer 322 may be an organic material, and the material of the insulating layer 321 may be an inorganic material.

Exemplarily, the inorganic material may be selected from at least one of silicon nitride (SiNx), silicon oxide (SiOx), silicon oxynitride (SiON), and the like. The organic material may be polyimide (PI), etc.

In some examples, during specific implementation, as shown in Figs. 6 to 8B, at least one of the plurality of common voltage lines 210 may include a plurality of signal line segments arranged at intervals. Exemplarily, each common voltage line 210 may include a plurality of signal line segments arranged at intervals. For example, the common voltage line 210 may include signal line segments 211-1 and 211-2. For example, in the same common voltage line 210, there is a line segment gap between two adjacent signal line segments, and one line segment gap may be located in one light-emitting cell PX.

In some examples, during specific implementation, as shown in Figs. 6 to 8B, the second conductive layer further includes a plurality of first bridge portions QB1 arranged at intervals from each other. In the same common voltage line 210, two adjacent signal line segments may be electrically connected through the first bridge portion QB1, so that the signal line segments may be electrically connected through the first bridge portion QB1 to transmit a signal. For example, the signal line segments 211-1 and 211-2 may be electrically connected through the first bridge portion QB1. The signal line segment 211-2 is electrically connected to the first bridge portion QB1 through the third via hole GK3, and the signal line segment 211-1 is electrically connected to the first bridge portion QB1 through the fourth via hole GK4. Exemplarily, in the same common voltage line 210, two adjacent signal line segments may be electrically connected through one, two, three or more first bridge portions QB1. Of course, the number of the first bridge portions QB1 connected between two adjacent signal line segments may be designed and determined according to the actual environment, and is not limited here.

In some examples, during specific implementation, as shown in Fig. 6 to Fig. 8B, in the same common voltage line 210, at least one first connection line 110 is at a line segment gap between two adjacent signal line segments. Exemplarily, in the same common voltage line 210, one first connection line 110 may be at a line segment gap between two adjacent signal line segments. For example, one first connection line 110 may be at a line segment gap between the signal line segments 211-1 and 211-2. Of course, in the same common voltage line 210, two, three or more first connection lines 110 may also be at a line segment gap between two adjacent signal line segments, which may be designed and determined according to the actual environment, and is not limited here.

In some examples, during specific implementation, as shown in Fig. 6 to Fig. 8B, at a line segment gap between two adjacent signal line segments, an orthographic projection of the first bridge portion QB1 on the base substrate 10 overlaps with an orthographic projection of a connection line 110 on the base substrate 10. In this way, the first bridge portion QB1 and the first connection line 110 have an overlapping area in a direction perpendicular to a plane where the base substrate 10 is located, which can reduce the extra space occupied by the first connection lines 110.

In some examples, during specific implementation, as shown in Fig. 6 to Fig. 8B, a voltage transmitted on the first bridge portion QB1 is less than a voltage transmitted on the first connection line 110. For example, a voltage of the common voltage line 210 may be a ground voltage, and then the first bridge portion QB1 may be a ground voltage, such as 0V. A voltage of the first connection line 110 may be a positive value, for example, 9V. Of course, in practical applications, the voltage of the common voltage line 210 and the voltage of the first connection line 110 can be designed and determined according to the actual application environment, and is not limited here.

In the embodiments of the present disclosure, as shown in Fig. 8A, if the voltage loaded to the first connection line 110 is greater than the voltage loaded to the first bridge portion QB1, there is an electric field between the first bridge portion and the first connection line of which orthographic projections on the base substrate 10 overlaps, and a direction F02 of the electric field points from the first conductive layer to the second conductive layer. Therefore, it can avoid the reduction reaction of the first connection line 110 as the cathode, and the oxidation reaction of the first bridge portion QB1 as the positive electrode. Moreover, the first bridge portion QB1 is protected by the second insulating layer 320, and the intrusion path of water and oxygen is relatively far. Therefore, the situation of electrochemical corrosion can be effectively reduced. Especially, for the metal connecting line of segment F shown in Fig. 1B, the situation of electrochemical corrosion can be effectively reduced.

In practical applications, in order to reduce electrochemical corrosion, the number of layers and the thickness of the first insulating layer 310 can be increased. In the embodiments of the present disclosure, if a voltage loaded to the first connection line 110 is greater than a voltage loaded to the first bridge portion QB1, a direction of an electric field generated between the first connection line 110 and the first bridge portion QB1 is a direction F02 pointing from the first connection line 110 to the first bridge portion QB1, which can effectively reduce the situation of electrochemical corrosion. Therefore, there is no need to additionally increase the number of layers and the thickness of the insulating layer, so as to save production capacity.

In some examples, during specific implementation, as shown in Fig. 6 and Fig. 7, the first connection line 110 may extend along the second direction F2. The second conductive layer may further include a first connection part BL1 and a second connection part BL2 arranged at intervals; where, a first terminal of the first connection line 110 is electrically connected to the first connection part BL1 through the first via hole GK1, and a second terminal of the first connection line 110 is electrically connected to the second connection part BL2 through the second via hole GK2. Where, the first via hole GK1 and the second via hole GK2 penetrate through the first insulating layer 310. Exemplarily, an orthographic projection of the first connection part BL1 on the base substrate 10 is located within an orthographic projection of the line segment gap on the base substrate 10, the orthographic projection of the first connection part BL1 on the base substrate 10 is located at a first end of the orthographic projection of the line segment gap on the base substrate 10, and the orthographic projection of the first connection part BL1 on the base substrate 10 does not overlap with the orthographic projection of the first bridge portion QB1 on the base substrate 10. An orthographic projection of the second connection part BL2 on the base substrate 10 is located within the orthographic projection of the line segment gap on the base substrate 10, the orthographic projection of the second connection part BL2 on the base substrate 10 is located at a second end of the orthographic projection of the line segment gap on the base substrate 10, and the orthographic projection of the second connection part BL2 on the base substrate 10 does not overlap with the orthographic projection of the first bridge portion QB1 on the base substrate 10.

In some examples, during specific implementation, as shown in Fig. 6 and Fig. 7, the first connection part BL1 is further electrically connected to one (such as PD1) of a plurality of pads, and the second connection part BL2 is further electrically connected to another pad (such as, PD2) of the plurality of pads. That is, one terminal of the first connection part BL1 is electrically connected to one pad (such as, PD1), and another terminal of the first connection part BL1 is electrically connected to the first terminal of the first connection line. One terminal of the second connection part BL2 is electrically connected to another pad (such as, PD2), and another terminal of the second connection part BL2 is electrically connected to the second terminal of the first connection line. In this way, a light-emitting element QD1 may be connected in series with another light-emitting element QD1 through the pad PD1, the first connection part BL1, the first connection line 110, the second connection part BL2 and the pad PD2.

In some examples, during specific implementation, as shown in Fig. 6 and Fig. 7, the orthographic projection of the first connection line 110 on the base substrate 10 covers the orthographic projection of the first via hole GK1 on the base substrate 10, and the orthographic projection of the first connection part BL1 on the base substrate 10 covers the orthographic projection of the first via hole GK1 on the base substrate 10. That is to say, a size of the first via hole GK1 cannot exceed a size of the first connection line 110 in the overlapping area, and the size of the first via hole GK1 cannot exceed a size of the first connection part BL1 in the overlapping area. In this way, the first connection line 110 can be in contact with the first connection part BL1 through the first via hole GK1 as much as possible, to improve the reliability of the electrical connection.

In some examples, in specific implementation, as shown in Fig. 6 and Fig. 7, a width W11 in the first direction F1 of the area where the first connection part BL1 covers the first via hole GK1 may be greater than a width W12 of the first connection line 110 in the first direction F1. In this way, the area where the first connection part BL1 covers the first via hole GK1 is not only greater than the area where the first via hole GK1 is located, but also greater than the area where the first connection line 110 covers the first via hole GK1, so that the connection part BL1 is in contact with the first connection line through the first via hole as much as possible, to improve the reliability of the electrical connection.

In some examples, during specific implementation, as shown in Fig. 7, a width W30 of the first bridge portion QB1 in the first direction F1 ranges from 100 microns to 250 microns. Exemplarily, the width W30 of the first bridge portion QB1 in the first direction F1 may be 100 micrometers. The width W30 of the first bridge portion QB1 in the first direction F1 may also be 150 microns. The width W30 of the first bridge portion QB1 in the first direction F1 may also be 200 microns. The width W30 of the first bridge portion QB1 in the first direction F1 may also be 250 microns. Of course, the specific value of the width W30 of the first bridge portion QB1 in the first direction F1 can be designed and determined according to the actual application environment, and is not limited here.

In some examples, during specific implementation, as shown in Fig. 7, a width W0 of the first connection line 110 in the first direction F1 ranges from 0.6 microns to 2.5 microns. Exemplarily, the width W0 of the first connection line 110 in the first direction F1 may be 0.6 microns. The width W0 of the first connection line 110 in the first direction F1 may also be 0.8 microns. The width W0 of the first connection line 110 in the first direction F1 may also be 1.0 microns. The width W0 of the first connection line 110 in the first direction F1 may also be 1.6 microns. The width W0 of the first connection line 110 in the first direction F1 may also be 2.0 microns. The width W0 of the first connection line 110 in the first direction F1 may also be 2.5 microns. Of course, the specific value of the width W0 of the first connection line 110 in the first direction F1 can be designed and determined according to the actual application environment, and is not limited here.

In some examples, during specific implementation, as shown in Fig. 7, a width W40 of a gap between the first connection line 110 and the signal line segment in the first direction F1 ranges from 20 microns to 50 microns. Exemplarily, the width W40 of the gap between the first connection line 110 and the signal line segment in the first direction F1 may be 20 microns. The width W40 of the gap between the first connection line 110 and the signal line segment in the first direction F1 may also be 25 microns. The width W40 of the gap between the first connection line 110 and the signal line segment in the first direction F1 may also be 30 microns. The width W40 of the gap between the first connection line 110 and the signal line segment in the first direction F1 may also be 35 microns. The width W40 of the gap between the first connection line 110 and the signal line segment in the first direction F1 may also be 40 microns. The width W40 of the gap between the first connection line 110 and the signal line segment in the first direction F1 may also be 50 microns. Of course, the specific value of the width of the gap between the first connection line 110 and the signal line segment in the first direction F1 can be designed and determined according to the actual application environment, and is not limited here.

In some examples, during specific implementation, as shown in Fig. 6 to Fig. 8A, the orthographic projection of the first connection line 110 on the base substrate 10 covers the orthographic projection of the second via hole GK2 on the base substrate 10, and the orthographic projection of the second connection part BL2 on the base substrate 10 covers the orthographic projection of the second via hole GK2 on the base substrate 10. That is to say, a size of the second via hole GK2 cannot exceed the size of the first connection line 110 in the overlapping area, and the size of the second via hole GK2 cannot exceed the size of the second connection part BL2 in the overlapping area. In this way, the first connection line 110 can be in contact with the second connection part BL2 through the second via hole GK2 as much as possible, to improve the reliability of the electrical connection.

In some examples, during specific implementation, as shown in Fig. 6 to Fig. 8A, a width W21 in the first direction F1 of the area where the second connection part BL2 covers the second via hole GK2 is greater than the width of the first connection line 110 in the first direction F1. In this way, the area where the second connection part BL2 covers the second via hole GK2 is not only greater than the area where the second via hole GK2 is located, but also greater than the area where the first connection line 110 covers the second via hole GK2, so that the second connection part BL2 is in contact with the first connection line through the second via hole as much as possible, to improve the reliability of the electrical connection.

In some examples, during specific implementation, as shown in Fig. 7 and Fig. 8B, a length of the first connection line 110 in the second direction F2 may be greater than a length of the first bridge portion QB1 in the second direction F2. In this way, the first via hole GK1 and the second via hole GK2 may be located on two sides of the first bridge portion QB1, and the first via hole GK1 and the second via hole GK2 do not overlap with the first bridge portion QB1, which reduces the possibility that the first bridge portion QB1 is short-circuited with the first connection line 110 through the first via hole GK1 and the second via hole GK2.

In some examples, during specific implementation, as shown in Fig. 7, the first bridge portion QB1 is a planar structure, and there is a first gap between a side of the first bridge portion QB1 extending to the first connection part BL1 and the first connection part BL1. A width X1 of the first gap ranges from 20 microns to 50 microns. Exemplarily, the width X1 of the first gap may be 20 microns. The width X1 of the first gap may also be 30 microns. The width X1 of the first gap may also be 40 microns. The width X1 of the first gap may also be 50 microns. Of course, in practical applications, the specific value of the width X1 of the first gap can be designed and determined according to the actual application environment, and is not limited here.

In some examples, during specific implementation, as shown in Fig. 7, the first bridge portion QB1 is a planar structure, and there is a second gap between a side of the first bridge portion QB1 extending to the second connection part BL2 and the second connection part BL2. A width X2 of the second gap ranges from 20 microns to 50 microns. Exemplarily, the width X2 of the second gap may be 20 microns. The width X2 of the second gap may also be 30 microns. The width X2 of the second gap may also be 40 microns. The width X2 of the second gap may also be 50 microns. Of course, in practical applications, the specific value of the width X2 of the second gap can be designed and determined according to the actual application environment, and is not limited here.

In some examples, during specific implementation, the width X1 of the first gap and the width X2 of the second gap may be approximately equal.

In some examples, during specific implementation, in a direction perpendicular to the plane where the base substrate 10 is located, a thickness of the first bridge portion QB1 may be equal to a thickness of other structures in the second conductive layer. For example, the thickness of the first bridge part QB1 is equal to the thickness of the first connection part and the second connection part. Exemplarily, the thickness of the first bridge portion QB1 may be equal to the thickness of the first connection part BL1 and the thickness of the second connection part BL2. In this way, when preparing the second conductive layer, an entire surface of the base substrate 10 is coated with a Cu film layer; then the Cu film layer is patterned through a patterning process; and then patterns of the first bridge portion QB1, the first connection part BL1, the second connection part BL2, the cascaded wire 240 and other structures in the second conductive layer may be formed at the same time.

In some examples, in a specific implementation, in a direction perpendicular to the plane where the base substrate 10 is located, the thickness of the first bridge portion QB1 may be greater than the thickness of other structures in the second conductive layer. By increasing the thickness of the first bridge portion QB1, the resistance of the first bridge portion QB1 can be reduced. For example, the thickness of the first bridge portion QB1 is greater than the thicknesses of the first connection part and the second connection part. Exemplarily, when preparing the second conductive layer, a Cu film layer may be coated on an entire surface of the base substrate 10; then the Cu film layer may be patterned through a patterning process; and then patterns of a first film layer of the first bridge portion QB1, the first connection part BL1, the second connection part BL2, the cascaded wire 240 and other structures in the second conductive layer may be formed at the same time. Then, one or more film layers are further arranged on the first film layer of the first bridge portion QB1 through a patterning process, so that these film layers form the first bridge portion QB1. Or, a Cu film layer may be coated on the entire surface of the base substrate 10, and then the Cu film layer is patterned using the grayscale mask through a patterning process, to form patterns of the first bridge portion QB1, the first connection part BL1, the second connection part BL2, the cascaded wire 240 and other structures in the second conductive layer at the same time, and make the thickness of the first bridge portion QB1 be greater than the thickness of other structures in the second conductive layer.

**In** some examples, during specific implementation, in the same light-emitting cell PX, at least two light-emitting elements QD1 are electrically connected through the first connection line 110. Exemplarily, one light-emitting element QD1 is electrically connected to another light-emitting element QD1 through the first connection part BL1. For example, the first connection part BL1 is electrically connected to the negative electrode of one light-emitting element QD1, and the first connection part BL1 is electrically connected to the first terminal of the first connection line 110. The second connection part BL2 is electrically connected to the positive electrode of another light-emitting element QD1, and the second connection part BL2 is electrically connected to the second terminal of the first connection line 110. In this way, one light-emitting element QD1 may be connected in series with another light-emitting element QD1 through the first connection part BL1.

In some examples, during specific implementation, as shown in Fig. 3, the plurality of light-emitting elements QD1 in the light-emitting cell PX may be divided into M element groups, and each element group includes N light-emitting elements QD1 arranged along the first direction F1; and M element groups are arranged along the second direction F2. Where, N is an integer greater than 0, and M is an integer greater than 0. Exemplarily, taking the light-emitting cell PX including 9 light-emitting elements QD1 as an example, M=3 and N=3 may be set. That is, the 9 light-emitting elements QD1 are divided into three element groups Z-1, Z-2, and Z-3. The element groups Z-1, Z-2 and Z-3 are arranged along the second direction F2. In addition, the element group Z-1 includes 3 light-emitting elements QD1 arranged along the first direction F1, the element group Z-2 also includes 3 light-emitting elements QD1 arranged along the first direction F1, and the element group Z-3 also includes 3 light-emitting elements QD1 arranged along the first direction F1.

In some examples, during specific implementation, as shown in Fig. 3, Fig. 6 and Fig. 7, in the same light-emitting cell PX, at least two element groups are electrically connected through the first connection line 110. Exemplarily, a plurality of element groups are numbered sequentially along the order of pointing from the driving voltage terminal to the output terminal; the first light-emitting element QD1 in the element group numbered 1 is electrically connected to the driving voltage terminal; the first light-emitting element QD1 in the element group numbered k is electrically connected to the first light-emitting element QD1 in the element group numbered k+1 through the first connection line 110; and the last light-emitting element QD1 in the element group numbered M is electrically connected to the output terminal; where 1<k<M and k is an integer. For example, taking the light-emitting cell PX including 9 light-emitting elements QD1 as an example, M=3, N=3 and k=2 may be set. The element group numbered 1 is Z-1, the element group numbered 2 is Z-2, and the element group numbered 3 is Z-3; the first light-emitting element QD1 in the element group numbered 1 is electrically connected to the driving voltage terminal; and the last light-emitting element QD1 in the element group numbered 1 is electrically connected to the last light-emitting element QD1 in the element group Z-2 numbered 2. The first light-emitting element QD1 in the element group Z-2 numbered 2 is electrically connected to the first light-emitting element QD1 in the element group Z-3 numbered 3 through the first connection line 110. The last light-emitting element QD1 in the element group Z-3 numbered 3 is electrically connected to the output terminal.

In some examples, during specific implementation, as shown in Fig. 3 and Fig. 6, the second conductive layer may further include a plurality of series wires 250 arranged at intervals; and the light-emitting elements QD1 in the same element group are electrically connected in series through the series wires 250. Exemplarily, the light-emitting elements QD1 are electrically connected to pads, and the pads are electrically connected to the series wires 250, so that the light-emitting elements QD1 in the same element group are electrically connected through the pads and the series wires 250.

**In** some examples, during specific implementation, as shown in Fig. 3 and Fig. 6, the last light-emitting element QD1 in the element group numbered k-1 is electrically connected to the last light-emitting element QD1 in the element group numbered k through the first connection line 110. Exemplarily, taking the light-emitting cell PX including 9 light-emitting elements QD1 as an example, M=3, N=3 and k=2 may be set. In the element group Z-1 numbered 1, the first light-emitting element QD1 and the second light-emitting element QD1 are electrically connected in series through one series wire 250, and the second light-emitting element QD 1 and the third light-emitting element QD 1 are electrically connected in series through one series wire 250. In the element group Z-2 numbered 2, the first light-emitting element QD1 and the second light-emitting element QD1 are electrically connected in series through one series wire 250, and the second light-emitting element QD1 and the third light-emitting element QD1 are electrically connected in series through one series wire 250. In the element group Z-3 numbered 3, the first light-emitting element QD1 and the second light-emitting element QD1 are electrically connected in series through one series wire 250, and the second light-emitting element QD1 and the third light-emitting element QD1 are electrically connected in series through a series wire 250. The last light-emitting element QD1 in the element group Z-1 numbered 1 is electrically connected to the last light-emitting element QD1 in the element group Z-2 numbered 2 through one series wire 250.

**In** some examples, during specific implementation, as shown in Fig. 6, an orthographic projection of the common voltage line 210 on the base substrate 10 does not overlap with an orthographic projection of the series wire 250 on the base substrate 10. In this way, a facing electric field between the common voltage line 210 and the series wire 250 may be avoided.

In some examples, during specific implementation, as shown in Fig. 3 and Fig. 6, for one column of light-emitting cells PX corresponding to a common voltage line 210, a source voltage line 230 and a driving voltage line 220, one driving voltage line 220 is between the element group Z-1 numbered 1 and the element group Z-2 numbered 2, one common voltage line 210 is between the element group Z-2 numbered 2 and the element group Z-3 numbered 3, and one source voltage line 230 is between an element group Z-1 numbered 1 in the adjacent light-emitting cell PX and the element group Z-3 numbered 3.

During specific implementation, in the embodiments of the present disclosure, as shown in Fig. 6 and Fig. 7, orthographic projections of pads on the base substrate do not overlap with an orthographic projection of the common voltage line 210 on the base substrate.

In some examples, during specific implementation, as shown in Fig. 3 and Fig. 6, two sides of the common voltage line 210 respectively have avoid areas, and pads on two sides of the common voltage line 210 are located in the avoid areas. For example, the pads electrically connected to the light-emitting elements QD1 in the element group Z-2 numbered 2 are located in the avoid area of a side, facing the driving voltage line 220, of the common voltage line 210; and the pads electrically connected to the light-emitting elements QD1 in the element group Z-3 numbered 3 are located in the avoid area of a side, away from the driving voltage line 220, of the common voltage line 210. That is to say, the orthographic projection of the common voltage line 210 on the base substrate does not overlap with orthographic projections of the pads electrically connected to the light-emitting elements QD1 in the element group Z-2 numbered 2 and orthographic projections of the pads electrically connected to the light-emitting elements QD1 in the element group Z-3 numbered 3 on the base substrate.

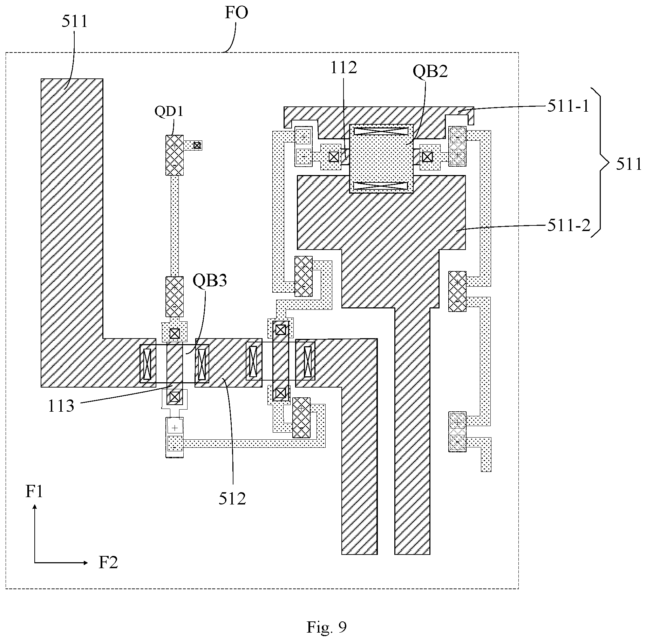

In some examples, during specific implementation, as shown in Fig. 9, the fan-out area FO may also include a plurality of light-emitting cells PX to increase the light-emitting area. It should be noted that the common voltage terminal in the light-emitting cell PX is electrically connected to a first fan-out line, and implementation of the light-emitting cells PX in the fan-out area FO may be basically the same as that of the light-emitting cells PX in the display area, that is, the specific implementation of the light-emitting cells PX in the fan-out area FO may refer to the above-mentioned implementation of the light-emitting cells PX in the display area, and details will not be repeated here.

In some examples, during specific implementation, as shown in Fig. 9, the first conductive layer may further include a plurality of first fan-out lines and a plurality of second connection lines 112 arranged at intervals, and the plurality of first fan-out lines and the plurality of second connection lines 112 are located in the fan-out area FO. Where, one common voltage line 210 is electrically connected to one first fan-out line. Moreover, at least one first fan-out line includes a first sub-fan-out line 511 and a second sub-fan-out line 512. The first sub-fan-out line 511 extends along the first direction F1, and the second sub-fan-out line 512 extends along the second direction F2. Moreover, the first sub-fan-out line 511 and the second sub-fan-out line 512 are electrically connected to each other to form a first fan-out line. That is, the first fan-out line has a right-angled portion.

In some examples, during specific implementation, as shown in Fig. 9, the second conductive layer may further include a plurality of second bridge portions QB2 arranged at intervals. Moreover, the plurality of second bridge portions QB2 are located in the fan-out area FO. The first sub-fan-out line 511 includes a plurality of first fan-out line segments arranged at intervals. In the same first sub-fan-out line 511, two adjacent first fan-out line segments are electrically connected through the second bridge portion QB2. For example, the first fan-out line segments 511-1 and 511-2 are electrically connected through the second bridge portion QB2. Moreover, at least one second connection line 112 is at a gap between two adjacent first fan-out line segments in the same first sub-fan-out line 511. At the gap between two adjacent first fan-out line segments in the first sub-fan-out line 511, the orthographic projection of the second bridge portion QB2 on the base substrate 10 overlaps with the orthographic projection of the at least one second connection line 112 on the base substrate 10. Exemplarily, in at least one light-emitting cell PX, at least two light-emitting elements QD1 are electrically connected through the second connection line 112.

**It** should be noted that both the first sub-fan-out line 511 and the common voltage line 210 extend along the first direction F1, and the implementation principle of the second connection line 112 and the second bridge portion QB2 is basically the same as that of the first connection line 110 and the first bridge portion QB1. Therefore, implementation of the second connection line 112 and the second bridge portion QB2 may be basically the same as that of the first connection line 110 and the first bridge portion QB1, that is, the specific implementation of the second connection line 112 and the second bridge portion QB2 may refer to that of the first connection line 110 and the first bridge portion QB1 above, and details will not be described here.

**In** some examples, during specific implementation, as shown in Fig. 9, the first conductive layer may further include a plurality of third connection lines 113. Where, in at least one light-emitting cell PX, at least two light-emitting elements QD1 are electrically connected through the third connection line 113. Exemplarily, some light-emitting elements QD1 in the same element group are electrically connected in series through the third connection line 113. For example, the second light-emitting element QD1 in the element group Z-1 numbered 1 is electrically connected in series with the third light-emitting element QD1 through a third connection line 113. The second light-emitting element QD1 in the element group Z-2 numbered 2 is electrically connected in series with the third light-emitting element QD1 through a third connection line 113.

In some examples, during specific implementation, as shown in Fig. 9, the second conductive layer further includes a plurality of third bridge portions QB3 located in the fan-out area FO. The second sub-fan-out line 512 includes a plurality of second fan-out line segments arranged at intervals. In the same second sub-fan-out line 512, two adjacent second fan-out line segments are electrically connected through the third bridge portion QB3; and at least one third connection line 113 is at a gap between two adjacent second fan-out line segments in the same second sub-fan-out line 512. At the gap between two adjacent second fan-out line segments in the second sub-fan-out line 512, an orthographic projection of the third bridge portion QB3 on the base substrate 10 overlaps with an orthographic projection of the third connection line 113 on the base substrate 10.

It should be noted that the second sub-fan-out line 512 is arranged vertically to the common voltage line 210, and therefore the implementation principle of the first connection line 110 and the first bridge portion QB1 after being rotated by 90 degrees may be basically the same as that of the third connection line 113 and the third bridge portion QB3. Therefore, the implementation of the third connection line 113 and the third bridge portion QB3 may be performed after rotating the first connection line 110 and the first bridge portion QB1 by 90 degrees, that is, the specific implementation of the third connection line 113 and the third bridge portion QB3 may refer to the above- implementation of the first connection line 110 and the first bridge portion QB1, and details will not be repeated here.

Based on the same disclosure concept, the embodiments of the present disclosure further provide a display apparatus, including the light-emitting substrate provided by the embodiments of the present disclosure. The principle of the display apparatus for solving the problem is similar to that of the foregoing light-emitting substrate. Therefore, implementation of the display apparatus may refer to the implementation of the foregoing light-emitting substrate, and repetition is not described herein.

In specific implementation, in the embodiments of the present disclosure, the display apparatus may be any product or component with a display function, such as a mobile phone, a tablet computer, a television, a display, a notebook computer, a digital photo frame and a navigator. Other essential components of the display apparatus are understood by those of ordinary skill in the art, which will not be repeated herein and should not be used as a limitation on the present disclosure.

Obviously, those skilled in the art may make various modifications and variations to the present disclosure without departing from the spirit and scope of the present disclosure. In this way, if these modifications and variations of the present disclosure fall within the scope of the claims of the present disclosure and the equivalent technologies, the present disclosure also intends to include these modifications and variations.

## Claims

1. A light-emitting substrate, comprising:
a base substrate;
a first conductive layer on the base substrate; wherein the first conductive layer comprises a plurality of common voltage lines and a plurality of first connection lines arranged at intervals; and the plurality of common voltage lines extend along a first direction and are arranged along a second direction;
a first insulating layer on a side, away from the base substrate, of the first conductive layer; and
a second conductive layer on a side, away from the base substrate, of the first insulating layer; wherein the second conductive layer comprises a plurality of first bridge portions arranged at intervals from each other;
wherein at least one of the plurality of common voltage lines comprises a plurality of signal line segments arranged at intervals;
in a same common voltage line, two adjacent signal line segments are electrically connected through the first bridge portion, and at least one first connection line is at a line segment gap between the two adjacent signal line segments; and
at the line segment gap between the two adjacent signal line segments in the common voltage line, an orthographic projection of the first bridge portion on the base substrate overlaps with an orthographic projection of the first connection line on the base substrate.

2. The light-emitting substrate according to claim 1, wherein an electric field is between the first bridge portion and the first connection line of which orthographic projections on the base substrate overlap; and
a direction of the electric field points from the first conductive layer to the second conductive layer.

3. The light-emitting substrate according to claim 1, wherein the second conductive layer further comprises a first connection part and a second connection part arranged at intervals from each other; and
a first terminal of the first connection line is electrically connected to the first connection part through a first via hole, and a second terminal of the first connection line is electrically connected to the second connection part through a second via hole;
wherein the first via hole and the second via hole penetrate the first insulating layer.

4. The light-emitting substrate according to claim 3, wherein the orthographic projection of the first connection line on the base substrate covers an orthographic projection of the first via hole on the base substrate, and an orthographic projection of the first connection part on the base substrate covers the orthographic projection of the first via hole on the base substrate; and
the orthographic projection of the first connection line on the base substrate covers an orthographic projection of the second via hole on the base substrate, and an orthographic projection of the second connection part on the base substrate covers the orthographic projection of the second via hole on the base substrate.

5. The light-emitting substrate according to claim 4, wherein a width in the first direction of an area where the first connection part covers the first via hole is greater than a width of the first connection line in the first direction; and
a width in the first direction of an area where the second connection part covers the second via hole is greater than the width of the first connection line in the first direction.

6. The light-emitting substrate according to claim 5, wherein a width of the first bridge portion in the first direction ranges from 100 microns to 250 microns; and
the width of the first connection line in the first direction ranges from 0.6 microns to 2.5 microns.

7. The light-emitting substrate according to claim 3, wherein a length of the first connection line in the second direction is greater than a length of the first bridge portion in the second direction.

8. The light-emitting substrate according to claim 7, wherein a first gap is between a side of the first bridge portion extending to the first connection part and the first connection part;
a second gap is between a side of the first bridge portion extending to the second connection part and the second connection part; and
at least one of a width of the first gap or a width of the second gap ranges from 20 microns to 50 microns.

9. The light-emitting substrate according to claim 3, wherein a width of a gap between the first connection line and the signal line segment in the first direction ranges from 20 microns to 50 microns.

10. The light-emitting substrate according to any one of claims 1-9, wherein in a direction perpendicular to a plane where the base substrate is located, a thickness of the first bridge portion is greater than or equal to a thickness of a first connection part and a second connection part in the second conductive layer.

11. The light-emitting substrate according to any one of claims 1-9, wherein the second conductive layer further comprises a plurality of pads;
one terminal of a first connection part is electrically connected to one of the plurality of pads, and another terminal of the first connection part is electrically connected to a first terminal of the first connection line; and
one terminal of a second connection part is electrically connected to another pad of the plurality of pads, and another terminal of the second connection part is electrically connected to a second terminal of the first connection line.

12. The light-emitting substrate according to any one of claims 1-9, wherein the plurality of common voltage lines are located in a display area; the display area further comprises a plurality of light-emitting cells; and each of the plurality of light-emitting cells comprises a driving circuit and a plurality of light-emitting elements;
wherein the driving circuit comprises a common voltage terminal and an output terminal; the plurality of light-emitting elements are sequentially connected in series between a driving voltage terminal and the output terminal; the common voltage terminal is electrically connected to the common voltage line; and pads are electrically connected to at least one of the plurality of light-emitting elements and the driving circuit;
the plurality of light-emitting elements in the light-emitting cell are divided into M element groups; each of the element groups comprises N light-emitting elements arranged along the first direction; the M element groups are arranged along the second direction; N is an integer greater than 0; and M is an integer greater than 0;
a plurality of element groups are numbered sequentially along an order of pointing from the driving voltage terminal to the output terminal;
a first light-emitting element in an element group numbered 1 is electrically connected to the driving voltage terminal;
a first light-emitting element in an element group numbered k is electrically connected to a first light-emitting element in an element group numbered k+1 through the first connection line; wherein 1<k<M and k is an integer;
a last light-emitting element in an element group numbered M is electrically connected to the output terminal; and
one column of light-emitting cells corresponds to one common voltage line, and the one common voltage line is located between the element group numbered k and the element group numbered k+1 in the one column of light-emitting cells.

13. The light-emitting substrate according to claim 12, wherein the second conductive layer further comprises a plurality of series wires arranged at intervals;
light-emitting elements in a same element group are electrically connected in series through the plurality of series wires;
a last light-emitting element in the element group numbered k-1 is electrically connected to a last light-emitting element in the element group numbered k through the series wire; and
orthographic projections of the plurality of common voltage lines on the base substrate do not overlap with orthographic projections of the plurality of series wires on the base substrate.

14. The light-emitting substrate according to any one of claims 1-9, wherein the light-emitting substrate further comprises a fan-out area;
the first conductive layer further comprises a plurality of first fan-out lines and a plurality of second connection lines in the fan-out area; wherein one of the plurality of common voltage lines is electrically connected to one of the plurality of first fan-out lines; the first fan-out line comprises a first sub-fan-out line and a second sub-fan-out line; the first sub-fan-out line extends along the first direction; and the second sub-fan-out line extends along the second direction;
the second conductive layer further comprises a plurality of second bridge portions in the fan-out area;
the first sub-fan-out line comprises a plurality of first fan-out line segments arranged at intervals;
in a same first sub-fan-out line, two adjacent first fan-out line segments are electrically connected through the second bridge portion, and at least one second connection line is at a gap between the two adjacent first fan-out line segments; and
at the gap between the two adjacent first fan-out line segments in the first sub-fan-out line, an orthographic projection of the second bridge portion on the base substrate overlaps with an orthographic projection of the second connection line on the base substrate.

15. The light-emitting substrate according to claim 14, wherein the first conductive layer further comprises a plurality of third connection lines;
the second conductive layer further comprises a plurality of third bridge portions in the fan-out area;
the second sub-fan-out line comprises a plurality of second fan-out line segments arranged at intervals;
in a same second sub-fan-out line, two adjacent second fan-out line segments are electrically connected through the third bridge portion, at least one third connection line is at a gap between the two adjacent second fan-out line segments; and
at the gap between the two adjacent second fan-out line segments in the second sub-fan-out line, an orthographic projection of the third bridge portion on the base substrate overlaps with an orthographic projection of the third connection line on the base substrate.

16. The light-emitting substrate according to claim 15, wherein the fan-out area comprises a plurality of light-emitting cells, and each of the plurality of light-emitting cells comprises a driving circuit and a plurality of light-emitting elements;
wherein the driving circuit comprises a common voltage terminal and an output terminal;
the plurality of light-emitting elements are sequentially connected in series between a driving voltage terminal and the output terminal;
the common voltage terminal is electrically connected to the first fan-out line; and
in at least one of the plurality of light-emitting cells, at least two of the plurality of light-emitting elements are electrically connected through the second connection line; and/or, at least two of the plurality of light-emitting elements are electrically connected through the third connection line.

17. A display apparatus, comprising the light-emitting substrate according to any one of claims 1-16.
